# EUROPÄISCHE PATENTSCHRIFT

(11) **EP 2 212 452 B1**
(45) Veröffentlichungstag und Bekanntmachung des Hinweises auf die Patenterteilung: **07.09.2011**
(21) Anmeldenummer: 08851057.3
(22) Anmeldetag: 18.11.2008
(51) Int. Cl.: C25D 7/06, C25D 17/00, C25D 17/12

(54) **VORRICHTUNG UND VERFAHREN ZUM ELEKTRISCHEN KONTAKTIEREN VON GUT IN ELEKTROLYTISCHEN DURCHLAUFANLAGEN**
DEVICE AND METHOD FOR THE ELECTRIC CONTACTING OF PRODUCTS IN ELECTROLYTIC FLOW-THROUGH SYSTEMS
DISPOSITIF ET PROCÉDÉ DE CONNEXION ÉLECTRIQUE D'UN ARTICLE DANS DES INSTALLATIONS DE TRAITEMENT ÉLECTROLYTIQUE EN CONTINU

(30) Priorität: 19.11.2007 DE 102007055338
(43) Veröffentlichungstag der Anmeldung: 04.08.2010
(73) Patentinhaber: RENA GmbH, 78148 Gütenbach (DE)
(72) Erfinder: HÜBEL, Egon, 90537 Feucht (DE)
(74) Vertreter: Stürken, Joachim
(86) Internationale Anmeldenummer: PCT/EP2008/009750
(87) Internationale Veröffentlichungsnummer: WO 2009/065557

(56) Entgegenhaltungen:
- EP-A- 0 264 510
- EP-A- 0 992 616
- DE-A1- 4 413 149
- US-B1- 6 471 846

## Beschreibung

Die Erfindung betrifft das elektrische Kontaktieren von elektrolytisch zu behandelndem Gut in Durchlaufanlagen mit horizontalem, schrägem oder vertikalem Transport des plattenförmigen oder bandförmigen Gutes. Insbesondere handelt es sich bei dem Gut um Wafer für Halbleiter und Solarzellen, bevorzugt aus Silizium; des Weiteren um Solarzellen auf Substraten aus Metall, Kunststoff und anderen Isolierwerkstoffen wie z.B. Glas. Die Erfindung eignet sich auch zur elektrolytischen Behandlung von flachem plattenförmigem oder bandförmigem Gut wie z.B. Leiterplatten und Leiterfolien, Hybridschaltungen, Bändern und dergleichen.

Die mit den Mitteln der Erfindung zu behandelnden vollflächigen oder strukturierten elektrisch leitfähigen Oberflächen des Gutes müssen zur elektrolytischen Behandlung in einem Elektrolyten kathodisch gegen mindestens eine Anode geschaltet sein, wenn es sich um einen Galvanisierprozess handelt. Beim elektrolytischen Ätzen ist das Gut anodisch gegen eine kathodische Gegenelektrode gepolt. Hierzu dient mindestens ein Gleichrichter oder Pulsgleichrichter, der im ersten Falle mit seinem Minuspol mit der zu behandelnden Oberfläche des Gutes und mit seinem Pluspol mit der Anode elektrisch leitend zu verbinden ist, beim elektrolytischen Ätzen entsprechend umgekehrt. In Durchlauf-Galvanisieranlagen wird das Gut kontinuierlich oder diskontinuierlich von rotierenden oder klammernden Transportmitteln transportiert. Diese Transportmittel übernehmen zugleich als Kontaktmittel die elektrische Kontaktierung des Gutes. Dabei werden diese Kontaktmittel wegen ihrer kathodischen Polarität beim Galvanisierprozess nahezu ebenso metallisiert wie die Oberfläche des Gutes. Diese Metallisierung der Kontaktmittel ist in Durchlauf-Galvanisieranlagen allgemein unerwünscht, da dies mit einem hohen Wartungsaufwand der Galvanisieranlage verbunden ist.

Im Stand der Technik sind in diesem Zusammenhang verschiedene Lösungen vorgeschlagen worden. So offenbart die DE 44 13 149 A1 eine Galvanisieranlage, bei der ein Kontaktrad mit Kontaktsektoren zum Einsatz kommt. Dabei sind die Kontaktsektoren am Kontaktrad einander gegenüberliegend angeordnet, wobei ein Kontaktsektor anodisch gepolt ist, während gleichzeitig ein anderer Kontaktsektor kathodisch gepolt ist. Metallreste am anodisch gepolten Sektor werden zusätzlich zu dem in unmittelbarer Nachbarschaft gelegenen kathodisch gepolten Kontaktsektor transportiert, so dass der kathodische Kontaktsektor noch stärker galvanisiert wird. Ein Entmetallisieren wird dadurch erschwert. In der DE 196 28 784 A1 werden noch mehr Kontaktsektoren vorgeschlagen, wobei die technische Realisierung eines Kontaktrades mit solchen mehreren Kontaktsektoren mit noch höherem Fertigungsaufwand verbunden ist. In der DE 196 28 784 A1 wird ferner darauf hingewiesen, dass sich beim Entmetallisieren eines solchen Kontaktrades unerwünschte grobkörnige Partikel bilden, die den Wartungsaufwand einer derartig ausgerüsteten Galvanisieranlage erhöhen. Die DE 198 40 471 A1 offenbart zusätzlich zu den in den oben erwähnten Schriften vorgeschlagenen Kontakträdern den Einsatz von Steuerungsmitteln, um in einem geeigneten Moment innerhalb eines sehr kurzen Zeitfensters die Kontaktsektoren kathodisch oder anodisch zu polen. Der Aufwand zum Betreiben einer solchen Anlage und zum Kontaktieren von zu beschichtendem Gut wird dadurch noch erhöht. In der EP 0578 699 B1 wird eine Kontaktwalze ohne Sektoren vorgeschlagen, wobei jeweils Hilfskathoden und semipermeable Membranen erforderlich sind. Die Hilfskathoden müssen häufig ausgewechselt werden, wodurch ebenfalls ein hoher Wartungsaufwand bedingt ist.

Es ist daher eine Aufgabe der Erfindung, eine einfache Vorrichtung und ein Verfahren anzugeben, mit dem flaches Galvanisiergut auf einfache Weise und zuverlässig kontaktiert werden kann, wobei der Wartungsaufwand der Galvanisieranlage verringert wird. Gelöst wird die Aufgabe durch eine Vorrichtung gemäß dem Patentanspruch 1 und durch ein Verfahren gemäß dem Patentanspruch 10. Vorteilhafte Ausgestaltungen sind in den Unteransprüchen beschrieben.

Die elektrische Kontaktierung des auf einer Durchlaufbahn durch eine elektrolytische Durchlaufanlage durchlaufenden Gutes erfolgt mit als Kontakträder ausgebildeten Rotationsteilen, die zugleich auch die Funktion von Transporträdern haben können, so dass ein Rotationsteil mit mehreren Funktionen gebildet ist. Erfindungsgemäß ist jedes Kontaktrad am Umfang mit nur einem einzigen bogenförmigen Kontakt versehen. Der verbleibende Teil am Umfang des Kontaktrades ist elektrisch isoliert. Der bogenförmige Kontakt wird nachfolgend Bogenkontakt genannt. Das Kontaktrad rollt bei der elektrolytischen Behandlung auf der zumindest partiell elektrisch leitfähigen Oberfläche des Gutes ab. Dabei wird diese durch den Bogenkontakt auf einer Länge in Transportrichtung elektrisch kontaktiert, die der Bogenlänge entspricht. Die Bogenlänge erstreckt sich über die Länge am Umfang des kreisförmigen Kontaktrades, die vom Zentriwinkel α bestimmt wird. Dieser Winkel kann in einem weiten Bereich variieren, z.B. von α - 45° bis 315°, bevorzugt wird jedoch ein Winkel α von 185° bis 200°. Die restliche Bogenlänge mit dem Winkel 360° - α ist mindestens auf der Lauffläche, d.h. am Umfang elektrisch isoliert. Wenn das rotierende Kontaktrad mit einem Bogenkontakt das Gut elektrisch kontaktiert, dann wird dieser Bogenkontakt gegenüber mindestens einer Anode der Durchlauf-Galvanisieranlage kathodisch geschaltet. In dieser Zeit wird nicht nur die Oberfläche des Gutes elektrolytisch metallisiert, sondern auch die Oberfläche des Bogenkontaktes. Bei der weiteren Rotation des Kontaktrades erreicht der elektrische isolierende Teil des Kontaktrades mit dem Winkel 360° - α die Oberfläche des Gutes. In dieser Zeit, in der der Bogenkontakt momentan nicht mit dem Gut in Kontakt ist, wird der Bogenkontakt anodisch gegen die elektrisch leitfähige Oberfläche des Gutes geschaltet, die in dieser Zeit als kathodische Gegenelektrode zum Bogenkontakt wirkt. Damit wird der Bogenkontakt elektrolytisch entmetallisiert und von der zuvor metallisierten Schicht befreit.

Bei jeder vollen Umdrehung des Kontaktrades wird somit der Bogenkontakt zeitlich nacheinander einmal nahezu wie das Gut kathodisch metallisiert und einmal anodisch entmetallisiert. Die Situation des ersten Kontaktrades soll nachfolgend mit dem Zusatz B bezeichnet werden. Ein weiteres Kontaktrad mit der Zusatzbezeichnung A der Durchlauf-Galvanisieranlage ist ebenso wie oben beschrieben gestaltet. Es rollt jedoch vom Kontaktrad B räumlich beabstandet und in Umlaufrichtung nominal in einem Winkel von 180° zum Kontaktrad A versetzt auf der elektrisch leitfähigen Oberfläche desselben Gutes ab. Die räumliche Beabstandung kann sowohl in Transportrichtung, quer zur Transportrichtung, oder senkrecht zum Kontaktrad B verlaufen. Der Winkelversatz wird nachfolgend als "Phasenverschiebung" bezeichnet. Die nominale Phasenverschiebung von 180° stellt den günstigsten theoretischen Wert dar. Jedoch sind hier auch Abweichungen in einem größeren Winkelbereich von z.B. ± 45° und mehr zulässig, dies insbesondere dann, wenn in der noch zu beschreibenden elektrischen oder elektronischen Steuereinheit die jeweils realisierte Phasenverschiebung zur Steuerung der Schaltmittel bekannt ist.

Mit den phasenverschobenen und voneinander beabstandet platzierten technisch überraschend einfachen Kontakträdern B und A ist es möglich, eine ununterbrochene kathodische Stromzufuhr zur vollflächigen oder mindestens partiell elektrisch leitfähigen Oberfläche des Gutes herzustellen, wobei diese partiellen Flächen elektrisch leitfähig miteinander verbunden sind.

Für die Anordnung der mindestens zwei Kontakträder A und B, die nachfolgend auch als Kontaktpaar bezeichnet werden, gibt es mehrere Möglichkeiten in Durchlauf-Galvanisieranlagen:
Nach einer bevorzugten Ausführungsform befindet sich das Kontaktrad A auf einer ersten Achse an der Oberseite der Transportbahn und das Kontaktrad B auf einer zweiten Achse an der gleichen Anlagenposition der Transportbahn an der Unterseite. Diese Anordnung ist z.B. bei der elektrolytischen Behandlung von Leiterplatten und Leiterfolien möglich, weil die Oberseite und die Unterseite des Gutes durch die vielen durchkontaktierten Löcher hindurch und über die metallisierten Ränder elektrisch miteinander verbunden sind. Auch bei anderem zu behandelndem Gut kommt diese Situation vor.

Soll das flache Gut nur einseitig, z.B. an der Unterseite galvanisiert werden, dann kann das Kontaktrad A an einem Rand oder auf einer ersten Spur des durchlaufenden Gutes abrollen. Das Kontaktrad B rollt dann in der selben Anlagenposition auf der selben Achse, jedoch auf dem beabstandeten gegenüber liegenden Rand oder auf einer zweiten Spur des Gutes, die von der ersten Spur beabstandet ist, ab. Die Ränder bzw. die Spuren sind, wie oben beschrieben, auf dem Gut elektrisch miteinander verbunden. In beiden Fällen ist die elektrische Kontaktierung an die Abmessungen bzw. an das Layout des Gutes gebunden. Diese Situation, d.h. konstante Formate und/oder konstantes Layout ist mehr und mehr in der Leiterplattentechnik und besonders auch in der Wafertechnik z.B. für Solarzellen gegeben.

Ist in einer Durchlauf-Galvanisieranlage mit unterschiedlichen Abmessungen des zu galvanisierenden Gutes zu rechnen, dann ist die einseitige Kontaktierung mit den Kontakträdern an der Oberseite und/oder an der Unterseite an einem Randbereich des Gutes oder auf mindestens einer Spur mit stets gleichem Randabstand vorzusehen. In diesem Falle wechseln sich die Kontakträder A und B in Transportrichtung und/oder oben und unten fortlaufend auf getrennten bzw. unterschiedlichen Achsen ab.

In allen Fällen können bei kleinerem parallel zu transportierendem Gut quer zur Transportrichtung auf einer Achse auch mehrere Kontakträder mit gleicher oder unterschiedlicher Phasenlage angeordnet sein.

Diese erfindungsgemäße elektrische Kontaktierung mittels eines einzigen Bogenkontaktes auf einem Kontaktrad erfordert keine Hilfskathode zur Entmetallisierung. Damit entfallen die beschriebenen Membranen mit dem zusätzlichen Elektrolyten. Des weiteren entfallen Produktionsunterbrechungen zur Entfernung und Verschrottung des nach dem Stand der Technik auf den Hilfskathoden abgeschiedenen Metalls. Durch die beabstandete Anordnung der beiden Kontakträder eines Kontaktpaares wird auch eine gegenseitig elektrolytische Metallisierung der Bogenkontakte auf den Kontakträdern sicher vermieden. Der Abstand kann groß bis sehr groß im Vergleich zu mehreren Kontaktsektoren, die sich nach DE 196 28 784 A1 oder DE 44 13 149 A1 gemeinsam auf einem Kontaktmittel befinden, realisiert werden. Dadurch findet die störende gegenseitige Metallisierung nicht statt.

Nach der elektrolytischen Abscheidung auf anodisch resistenten und oxidierenden Werkstoffen kann es beim Entmetallisieren vorkommen, dass dieser Vorgang aufgrund der Bildung einer Passivierungsschicht an dem Werkstoff nicht vollständig gelingt. Das beschriebene Entmetallisierungsproblem von elektrolytischen Abscheidungen auf anodisch resistenten und oxidierenden Werkstoffen im verwendeten Elektrolyten kann zum Beispiel durch eine besondere Beschichtung der Bogenkontakte gelöst werden. Geeignet ist eine elektrisch leitfähige Diamantschicht, die an der Kontaktfläche am Umfang des Bogenkontaktes vorgesehen ist. Die Leitfähigkeit der Diamantschicht wird durch eine Dotierung z.B. mit Bor hergestellt. Damit verhalten sich auch oxidierende Metalle mit einer derartigen Beschichtung von z.B. 5 µm bis 15 µm Dicke in einer elektrolytischen Zelle anodisch und kathodisch so wie nicht oxidierende Metalle, d.h. wie z.B. Edelmetalle. Die Oberflächen der Bogenkontakte lassen sich damit elektrolytisch vollkommen entmetallisieren.

Weil die Kontaktoberfläche in Folge der Diamantbeschichtung keine Oxidschicht aufweist, wird auch der KontaktÜbergangswiderstand wesentlich verringert. Dies auch dann, wenn die Kontaktkraft im Vergleich zur erforderlichen Kontaktkraft bei Oxid behafteten Kontaktoberflächen klein ist. Wegen des kleineren Kontakt-Übergangswiderstandes ist auch der Spannungsabfall an diesem Kontakt beim elektrischen Kontaktieren kleiner. Damit ist der Bogenkontakt in Bezug zum Galvanisiergut ebenfalls weniger kathodisch. Die beim Stand der Technik beschriebene bevorzugte, jedoch unerwünschte Metallisierung des Kontaktes wird verringert. Der Spannungsabfall am Kontakt wird durch die nicht oxidierende Kontaktoberfläche aus Diamant gegenüber z.B. einer Titanoberfläche etwa halbiert.

Im Gegensatz zu einer möglichen Edelmetallbeschichtung ist die Diamantbeschichtung extrem abriebfest und verschleißfest. Diese Eigenschaften sind ein zusätzlicher großer Vorteil für die erfindungsgemäßen Bogenkontakte in Durchlauf-Galvanisieranlagen, und erlauben auch den Einsatz bei scharfkantigem Gut wie Leiterplatten oder Siliziumwafern.

Beim Galvanisieren von z.B. Leiterplatten oder Leiterfolien sind die zu metallisierenden Startschichten für die HDI-Technik sehr dünn, z.B. 3 µm. Bei großen Stromdichten verursachen die damit verbundenen Galvanisierströme in der dünnen Startschicht große Spannungsabfälle. Diese verursachen unzulässig große Schichtdickenunterschiede mit der größten Dicke am Rand des Kontaktbereiches und abnehmend zum gegenüber liegenden Bereich des Gutes. Durch die Anordnung eines Kontaktpaares auf einer Achse mit Kontakträdern, die an den beiden Rändern des Gutes abrollen, erfolgt die Stromeinleitung zeitlich nacheinander abwechselnd von den beiden Rändern an derselben Position der Anlage. Dadurch heben sich die Nachteile der einseitigen Kontaktierung gegenseitig so auf, dass eine nahezu ebene Schicht quer zur Transportrichtung erzielt wird.

Weitere Details der Erfindung werden an Hand der schematischen und nicht maßstäblichen Figuren 1 bis 8 beschrieben.
**Figur 1** zeigt in der Seitenansicht ein Kontaktrad mit dem Bogenkontakt.
**Figur 2** zeigt eine grundsätzliche Anordnung der Kontaktmittel in einer elektrolytischen Zelle und die zugehörige elektrische Schaltung.
**Figur 3** zeigt eine Anordnung der Kontaktmittel an der Oberseite und an der Unterseite des Gutes.
**Figur 4** zeigt eine weitere Anordnung mit einer anderen Phasenlage der Bogenkontakte.
**Figur 5** zeigt eine elektrische Schaltung zur Entmetallisierung der Kontaktmittel mittels der Gleichrichter zur Galvanisierung des Gutes.
**Figur 6** zeigt desgleichen eine Anordnung zur Galvanisierung der Oberseite und der Unterseite des Gutes.
**Figur 7** zeigt einen Ausschnitt aus einer Anlage mit Kontaktmitteln an einer Seite des Gutes mit Entmetallisierungs-Gleichrichtern.
**Figur 8** zeigt desgleichen einen Ausschnitt aus einer Anlage ohne gesonderte Entmetallisierungs-Gleichrichter und mit mehreren Anoden je Galvanogleichrichter.

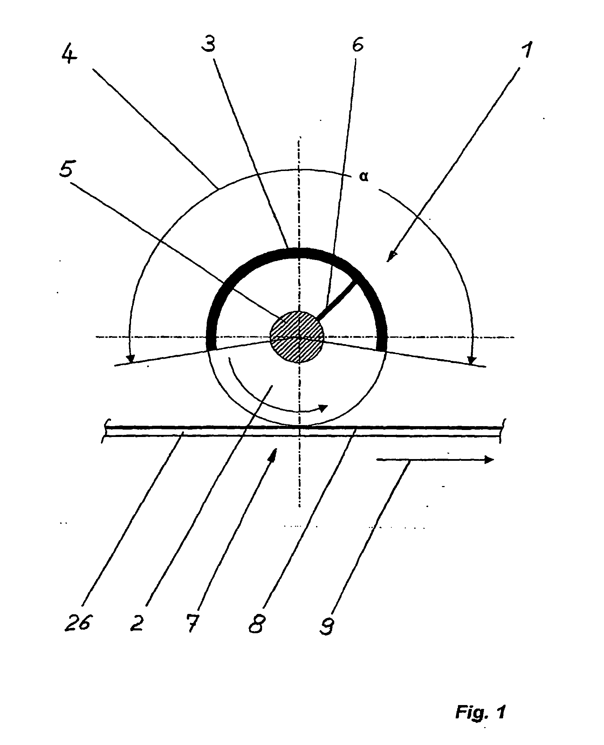

Die **Figur 1** zeigt das Kontaktrad 1 bestehend aus einem Isolierkörper 2 und einem Bogenkontakt 3. Der Bogenkontakt 3 erstreckt sich am Umfang des Kontaktrades 1 über die Bogenlänge 4. Diese kann auch durch den Zentriwinkel α beschrieben werden. In Figur 1 erstreckt sie sich über den Winkel α, der größer ist als 180°. Dieser Winkel kann jedoch auch wesentlich kleiner oder wesentlich größer als 180° gewählt werden, z.B. von 45° bis 315°, bevorzugt 185° bis 200°. Das Kontaktrad 1 befindet sich auf einer Achse 5, die von einem nicht dargestellten Antrieb in Rotation versetzt wird. Vorteilhaft wird die Achse 5 mindestens teilweise elektrisch leitfähig ausgeführt. Damit kann sie auch als Stromleiter zum Bogenkontakt 3 genutzt werden. Der Bogenkontakt 3 wird mittels mindestens eines elektrischen Leiters 6 als Lasche, Draht, Stift, Schraube oder Metallstück mit der Achse 5 verbunden. Die mechanische Verbindung von Bogenkontakt 3 und Isolierkörper 2 kann z.B. durch Schrauben oder formschlüssig durch mindestens einen Hinterschnitt erfolgen. Derartige Verbindungen sind als Schwalbenschwanzverbindungen bekannt. Seitlich können die so zusammengefügten Teile geführt werden, z.B. durch beidseitig elastische Scheiben und entsprechende rohrförmige Druckkörper, die gegen die Scheiben drücken.

Die Stromzuführung zur rotierenden Achse 5, die an ihrer Oberfläche elektrisch isoliert ist, erfolgt über mindestens einen hier nicht dargestellten Drehkontakt oder Schleifkontakt, der außerhalb des Elektrolyten angeordnet ist. Der Isolierkörper 2 kann aus Kunststoff, Oxidkeramik oder einem anderen elektrisch isolierenden Werkstoff bestehen.

Bei einer weiteren Ausgestaltung des Kontaktrades 1 sind der Bogenkontakt 3 und der Isolierkörper 2 invers ausgeführt. Der Kontakt hat die Form des dargestellten Isolierkörpers 2 der Figur 1 und der Isolierbereich hat die Form des Bogenkontaktes 3 mit individueller Bogenlänge. In diesem Falle entfällt der elektrische Leiter 6, weil sich der metallische Kontakt bis zur elektrisch leitenden Achse 5 erstreckt und dort mit dieser z.B. durch Klemmung verbunden ist.

Auf einer Achse 5 können sich auch mehrere Kontakträder 1 beabstandet befinden, wenn das Abrollen auf der zu nutzenden Oberfläche des Gutes zulässig ist. Gleiches gilt, wenn quer zur Transportrichtung mehrere Teile zu transportieren und zu kontaktieren sind. Dieser Fall ist z.B. beim Galvanisieren von Wafern, Solarzellen oder Hybriden gegeben. Auf jedem derartigen Gut 7 verläuft mindestens in Transportrichtung gesehen eine Kontaktspur für das bzw. die Kontakträder auf der vollflächigen oder strukturierten elektrischen Leitschicht 8, die zu Beginn der elektrolytischen Behandlung als Startschicht bezeichnet wird. Die Kontaktspur befindet sich dabei außerhalb eines für eine spätere Nutzung zu galvanisierenden Gutes.

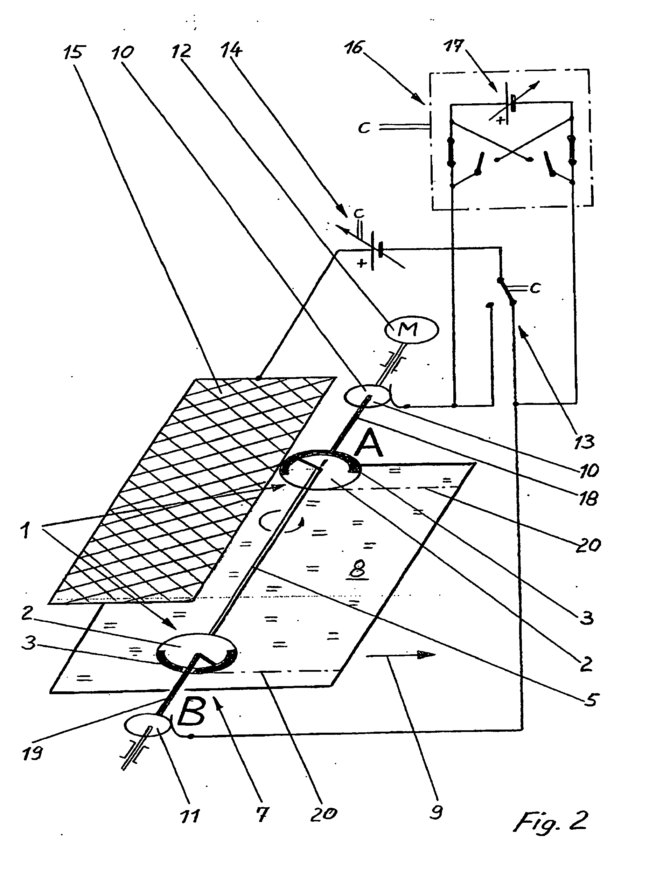

In der **Figur 2** sind zwei Transport- und Kontakträder 1 mit gemeinsamer Achse 5, die auf der Leitschicht 8 an der Oberseite des Gutes 7 an den beiden Rändern abrollen, dargestellt. Die Randbereiche des Gutes 7 sind mit A und B bezeichnet. Das Kontaktrad 1 am Rand A, nachfolgend auch kurz mit Kontaktrad 1 A bezeichnet, ist mit seinem Bogenkontakt 3 über den dortigen elektrisch leitfähigen und an einem Achsende liegenden Achsbereich 18 A mit einem Schleifkontakt oder Drehkontakt 10 leitfähig verbunden. Das Kontaktrad 1 am Rand B, d.h. das Kontaktrad 1 B ist entsprechend über den am anderen Achsende liegenden Achsbereich 19 B mit einem Schleifkontakt 11 elektrisch leitfähig verbunden. Die Achse 5, die in diesem Anwendungsfalle im Mittenbereich zumindest teilweise im gesamten Querschnitt elektrisch isoliert ist, wird von einem Antrieb 12 in Rotation versetzt.

Diese Art der Stromzuführung mittels Schleif- oder Drehkontakten zu den rotierenden Kontakträdern 1 einschließlich der Kontakträder 1 selbst ist konstruktiv einfach und damit auch sehr kostengünstig realisierbar. Besonders vorteilhaft ist die Verwendung von Drehkontakten außerhalb der elektrolytischen Zelle, wenn die Durchlauf-Galvanisieranlage in einem Reinraum aufgestellt werden soll, denn es wird der übliche Schleifstaub von Schleifkontakten oder Kommutatoren vermieden.

Bei der in Figur 2 dargestellten Ausführungsform kontaktiert momentan der Bogenkontakt 3 des Kontaktrades 1 B die zu galvanisierende elektrisch leitfähige Oberfläche des Gutes 7. Damit ist mindestens die gesamte Oberseite des Gutes 7 über ein als Umschalter 13 ausgebildetes elektronisches oder elektromechanisches Schaltmittel mit dem negativen Pol einer variablen Galvanisierstromquelle oder kurz Gleichrichter 14 genannt, elektrisch verbunden. Diese Oberseite ist somit im Elektrolyten kathodisch geschaltet gegen die lösliche oder unlösliche Anode 15, die mit dem positiven Pol des Gleichrichters 14 elektrisch verbunden ist. Durch diese Polung wird die Oberseite im Elektrolyten metallisiert. Zugleich wird auch unerwünscht der kathodische Bogenkontakt 3 des Kontaktrades 1 B metallisiert.

Bei dieser dargestellten momentanen Rotationssituation rollt am Kontaktrad 1 A der Isolierkörper 2 auf der Oberfläche des Gutes 7 ab. Der Bogenkontakt 3 des Kontaktrades 1 A ist nicht mit dem Gleichrichter 14 verbunden. Diese Situation wird zur elektrolytischen Entmetallisierung des zuvor unerwünscht metallisierten Bogenkontaktes 3 genutzt. Hierzu dient ein elektronischer oder elektromechanischer Entmetallisierungs-Gleichrichter 17. Dieser wird über eine Umpolschaltung 16 und über den Schleifkontakt 10 momentan mit dem Bogenkontakt 3 des Kontaktrades 1 A elektrisch verbunden. Die Stellung der Umpolschaltung ist dabei so, dass der Pluspol des Entmetallisierungs-Gleichrichters 17 mit dem Bogenkontakt 3 verbunden ist und diesen anodisch gegen die Oberfläche des Gutes 7 polt. Zugleich ist der Minuspol dieses Gleichrichters 17 über den Schleifkontakt 11 und den Bogenkontakt 3 des Kontaktrades 1 B mit der Oberfläche des Gutes 7 elektrisch verbunden. Diese Oberfläche wirkt damit als Gegenelektrode zum anodischen Bogenkontakt 3 des Kontaktrades 1 A.

Die Verwendung von separaten Gleichrichtern 14, 17 zur Metallisierung und zur Entmetallisierung ermöglicht die individuelle und optimale Anpassung der beiden unterschiedlichen elektrolytischen Prozesse, für das Metallisieren und das Entmetallisieren. So kann z.B. bei einer großen Bogenlänge des Bogenkontaktes 3 für die dann entsprechend kleinere Entmetallisierungszeit pro Umdrehung am Entmetallisierungs-Gleichrichter 17 eine größere Badspannung und damit eine größere Stromdichte zur Beschleunigung der Entmetallisierung eingestellt werden.

Weil die Oberfläche des Gutes 7 bei der Entmetallisierung als kathodische Gegenelektrode zum Bogenkontakt 3 wirkt, wird diese im Bereich der Kontaktspur 20 A metallisiert. Damit wird der Abscheidungsverlust durch die zwischen dem Gut 7 und der Anode 15 befindlichen abschirmenden Kontakträder 1 nahezu ausgeglichen. Dies ist besonders dann wichtig, wenn die Kontakträder 1 und damit die Kontaktspuren 20 durch nicht dargestellte Abschirmhauben zur Verringerung der unerwünschten Metallisierung der Kontakträder 1 abgeschirmt sind. Die Abschirmhauben 22 aus einem Isolierwerkstoff mit entsprechender Baugröße über den Kontakträdern sind an der Seite, die zur Oberfläche des Gutes 7 weisen, geöffnet.

Die Bogenkontakte 3 der Kontakträder 1 A und B sind während einer Umdrehung entweder kathodisch oder anodisch gepolt. Die gleichzeitige kathodische und anodische Polung durch entsprechende Schaltstellungen des Umschalters 13 und der Umpolschaltung 16 würde zu einem elektrischen Kurzschluss der beiden Gleichrichter 14, 17 führen. Deshalb muss jeder Bogenkontakt 3 während einer Umdrehung des Kontaktrades 1 zeitlich nacheinander kathodisch und anodisch schaltbar sein. Für die zeitlich korrekte sequenzielle Schaltung der beiden Polaritäten an jedem Bogenkontakt 3 sorgt eine zentrale Steuereinheit C der Durchlaufanlage. Diese synchronisiert und steuert bzw. regelt alle beteiligten Stromquellen 14, 17, die Schaltmittel 13, 16 und des Antriebes 12 der Rotationsteile sowohl zeitlich als auch verfahrenstechnisch, d.h. die Ströme bzw. Stromdichten der Stromquellen und ihre Polaritäten sowie die Antriebsgeschwindigkeiten. Die Steuereinheit C ist im Vergleich zu einem elektromechanischen Kommutator durch die elektronischen Programmierungsmöglichkeiten wesentlich flexibler. Auf Prozessänderungen kann durch Programmierung reagiert werden. Des Weiteren können unipolare Pulse, d.h. Stromlücken steuernd realisiert werden.

Die Steuereinheit C, die Gleichrichter 14, 17, die Antriebe 12 und die Schaltmittel 13, 16 werden bevorzugt mit elektronischen Mitteln realisiert. Diese Mittel können auch Bestandteil der Gleichrichter selbst sein. Jedoch sind auch elektromechanische Ausführungen, so wie sie in den Figuren zur besseren Übersicht dargestellt sind, für die Erfindung anwendbar.

Durch die Synchronisation der Schaltmittel mit dem Antrieb wird vorteilhaft sichergestellt, dass am Bogenkontakt 3 kein Stromabriss mit störender Funkenbildung auftritt. Wenn die Bogenkontakte 3 der Kontakträder 1 A und B Bogenlängen 4 aufweisen, die zu Winkeln α korrespondieren, die größer sind als 180°, z.B. 200°, dann tritt für einen Phasenwinkel von 20° eine Überlappung auf. In dieser Überlappungszeit kontaktieren beide Bogenkontakte die Oberfläche des Gutes 7. Wird in der Überlappungszeit der Umschalter 13 betätigt, dann entsteht weder ein Einschaltfunke an der einen einschaltenden Kante noch ein Abrissfunke an der anderen ausschaltenden Kante der Bogenkontakte. Dadurch wird ein entsprechender Verschleiß der Bogenkontakte vermieden und die Oberfläche des Gutes erleidet keine Funkenerosion. Während der Überlappungszeit ist der Entmetallisierungs-Gleichrichter 17 zur Kurzschlussvermeidung vollständig ausgeschaltet. Hierzu können z.B. alle Schaltmittel der Umpolschaltung 16 geöffnet werden.

Bei der in Figur 2 dargestellten Ausführungsform verliert bei weiterer Rotation der Kontakträder 1 das Kontaktrad 1 B den elektrischen Kontakt zum Gut, während das Kontaktrad 1 A beginnt, das Gut 7 zu kontaktieren. Bei diesem Wechsel von B nach A wird auch der Umschalter 13 von der steuernden Steuereinheit C umgeschaltet, wodurch das Kontaktrad 1 A über den Bogenkontakt 3 die Oberfläche des Gutes kathodisch kontaktiert. In diesem Schaltzustand hat der Bogenkontakt 3 des Kontaktrades 1 B keine elektrische Verbindung zum Gut und zum Gleichrichter 14. Dieser Bogenkontakt 3 wird über die Umpolschaltung 16 an den positiven Pol des Entmetallisierungs-Gleichrichters 17 geschaltet. Die Oberfläche des Gutes 7 wirkt als kathodische Gegenelektrode, weil diese momentan mit dem negativen Pol des Entmetallisierungs-Gleichrichters 17 über das Kontaktrad 1 A elektrisch verbunden ist. Der Bogenkontakt 3 des Kontaktrades 1 B wird damit anodisch entmetallisiert, wobei das im Elektrolyten aufgelöste Metall des Bogenkontaktes 3 auf der Oberfläche des Gutes 7 im Bereich der Kontaktspur 20 nutzbringend abgeschieden wird.

Bei weiterer Drehung verliert wieder das Kontaktrad 1 A die elektrische Verbindung zum Gut und das Kontaktrad 1 B übernimmt die Kontaktierung. Dieser Wechsel wiederholt sich bei der Rotation der Kontakträder 1 und damit beim Transport des Gutes fortwährend. Die Anordnung der Kontakträder 1 A und B auf der Achse 5 und ihre Positionierung in Bezug zum Gut 7 beschränkt sich nicht auf das Beispiel der Figur 2. In Abhängigkeit vom elektrolytisch zu behandelnden Gut können Kontakträder 1 nur an einem Rand des Gutes oder an der Oberseite und an der Unterseite angeordnet werden, wie es z.B. bei Leiterplatten und Leiterfolien erforderlich ist.

In Figur 2 ist die Anode 15 in Transportrichtung mit kurzer Ausdehnung dargestellt. In der Praxis kann die Anode in dieser Richtung auch wesentlich länger ausgeführt sein und von einem Gleichrichter 14 gespeist werden. Es ist bevorzugt auch möglich, mehrere voneinander getrennte Anoden als Gruppe in Transportrichtung des Gutes 7 anzuordnen, wobei jede der Anoden einer Gruppe von ein und demselben größeren Gleichrichter gespeist wird. Dies reduziert die Kosten für viele einzelne Gleichrichter einschließlich ihrer Regel- und Steuergeräte, wenn eine individuelle Anodenstromregelung nicht erforderlich ist. Gleiches gilt für einzelne schmale Anoden, die quer zur Transportrichtung angeordnet sind. Dieser Fall ist gegeben, wenn z.B. das einzelne Gut in dieser Richtung kleine Abmessungen aufweist, oder schmale Bänder zu behandeln sind. Auch hierfür können mehrere Anoden von einem Gleichrichter gespeist werden. In diesem Falle befinden sich dann auch mehrere Kontakträder 1 auf einer Achse, die das jeweilige schmale Gut kontaktieren. Diese Kontakträder 1 sind entweder alle vom Typ A, d.h. die Phasenlage der Bogenkontakte 3 auf einer Achse ist gleich. Auf der in Transportrichtung benachbarten Achse sind dann alle Kontakträder 1 vom Typ B. Auch abwechselnde Anordnungen vom Typ A und B auf einer Achse sind für ein schales Gut realisierbar. Derartige Ausführungsbeispiele und weitere elektrische Schaltungsmöglichkeiten der Erfindung werden an Hand der nachfolgenden Figuren beschrieben, wobei darüber hinaus weitere Ausführungen und Anordnungen möglich sind.

Die Erfindung wird überwiegend am Beispiel der elektrolytischen Metallisierung beschrieben, weil dies eine bevorzugte Anwendung ist. Sie ist jedoch auch für die elektrolytischen Prozesse Entmetallisieren, Oxidieren und Reduzieren anwendbar. Es sind lediglich die Polaritäten der Stromquellen an die Prozesse anzupassen.

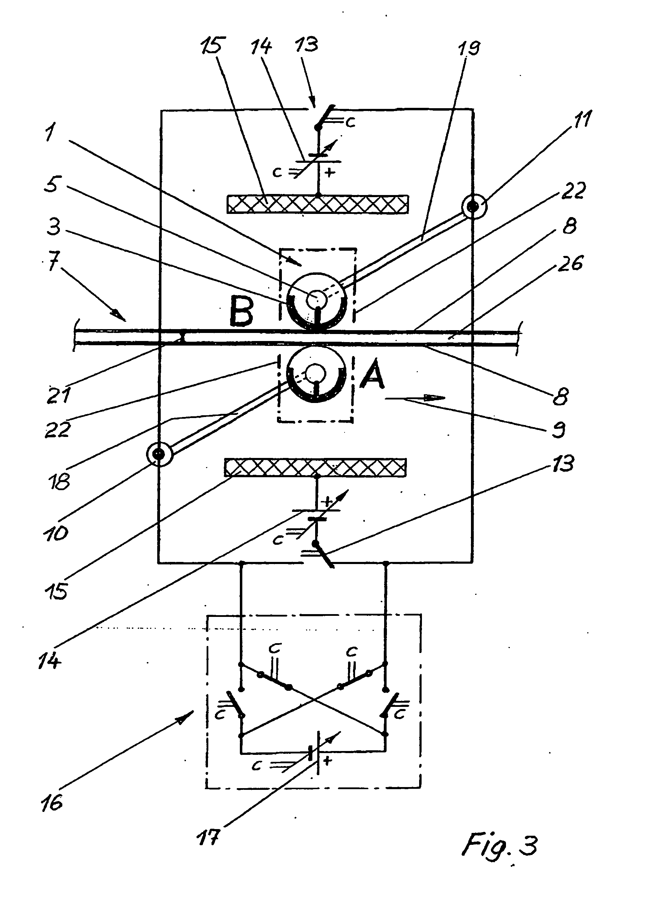

Die **Figur 3** zeigt im Querschnitt das Gut 7, das an der Oberseite und an der Unterseite mit elektrischen Leitschichten 8 versehen ist, die metallisiert werden sollen. Diese beiden strukturierten oder vollflächigen Leitschichten 8 sind elektrisch miteinander verbunden. Bei Leiterplatten erfolgt diese Verbindung durch die durchkontaktierten Löcher und durch die dabei auch metallisierten Kanten. Auch bei anderen Produkten besteht diese elektrische Verbindung der beiden Seiten, z.B. über die Kanten oder sie kann bei Bedarf durch eine leitfähige Brücke 21 gebildet werden.

Die Kontakträder 1 A und B sind bevorzugt konstruktiv gleich ausgebildet. Sie sind jedoch in ihrer Winkelstellung um nominal 180° versetzt an derselben Position in Transportrichtung 9 des Gutes 7 gesehen angeordnet. Dieser Winkelversatz oder auch Phasenlage genannt, wird bei diesem Paar von Kontakträdern 1 und bei allen anderen Kontakträdern 1 der gesamten Anlage konstant gehalten, z.B. durch einen formschlüssigen Zahnradantrieb der Kontakträder 1, die einen gleich großen Außendurchmesser haben. Die elektrischen Abläufe entsprechen den an Hand der Figur 2 beschriebenen Abläufen und Schaltvorgängen. Dabei können auch von der symbolisch mit dem Buchstaben C dargestellten Steuereinheit die Gleichrichter in ihren Amplituden, d.h. in den Spannungen und/oder Strömen verändert werden. Dies kennzeichnen die Pfeile in den Gleichrichtersymbolen.

Damit die Metallisierung des Kontaktrades 1 eingeschränkt wird, indem es in der momentanen Phasenlage B nicht direkt von den Feldlinien der Anode 15 erreicht werden kann, wird es mittels einer Abschirmhaube 22, bestehend aus einem elektrischen Isolator, geschützt. Diese Abschirmhauben sind an den Seiten, die zum Gut 7 weisen, offen. Sie behindern damit nicht die beschriebenen Vorgänge an der Oberfläche des Gutes. Jede der beiden Anoden 15 wird von einem individuellen Gleichrichter 14 gespeist. Zur Vermeidung des technischen Aufwandes kann z.B. der Gleichrichter 14 an der Unterseite entfallen. Diese Anode ist dann mit der Anode an der Oberseite elektrisch zu verbinden, d.h. parallel zu schalten. Der Gleichrichter an der Oberseite speist dann beide Anoden in einer Gruppe. Er muss für die größere Leistung dimensioniert werden, was stets kostengünstiger ist, als zwei kleine Gleichrichter. Diese Parallelschaltung empfiehlt sich immer dann, wenn an der Oberseite und an der Unterseite gleich große Flächen mit gleichen Stromdichten elektrolytisch zu behandeln sind.

Auch mehrere Anoden 15, in Transportrichtung gesehen, können von einem gemeinsamen Gleichrichter gespeist werden. Befinden sich die Kontakträder 1 der Figur 3 nur an einem Rand des Gutes, so kann beliebig breites Gut, quer zur Transportrichtung 9 gesehen, produziert werden. Es können auch mehrere Kontakträder 1 auf einer Achse angeordnet werden, wenn schmales Gut parallel transportiert werden soll. Dies ist nicht nur bei Solarzellen, Hybriden und Bändern der Fall, sondern auch bei Smart Labels bzw. Smart Cards für RFID Produkte. Diese können außerhalb ihres Leiterbildes elektrisch leitfähige Spuren zur elektrischen Kontaktierung durch die Kontakträder 1 aufweisen. Diese Spuren haben zunächst elektrische Verbindungen zu den Leiterbildern, die jeweils meist eine gedruckte Spule als Antenne darstellen. Nach dem Galvanisieren der Antenne wird diese ausgestanzt und dabei auch von der Galvanisierspur getrennt. Damit ist auch das Problem der Galvanisierung von Strukturen der Antennen sehr kostengünstig lösbar.

In Figur 3 ist nur ein Paar von Kontakträdern 1 dargestellt. In Transportrichtung können sich die Kontakträder 1 jeder Seite mit der gezeichneten Phasenlage fortsetzen, was konstruktiv sehr einfach ist; insbesondere auch bei Wartungs-und Reinigungsarbeiten, weil alle Kontaktelemente einer Seite gleich sind. Wenn die elektrisch leitfähige Verbindung von der Oberseite zur Unterseite mit einem zu großen elektrischen Widerstand behaftet ist, dann empfiehlt es sich, die Kontakträder 1 A und B an jeder Seite abwechselnd und zugleich von der Oberseite zur Unterseite abwechselnd anzuordnen.

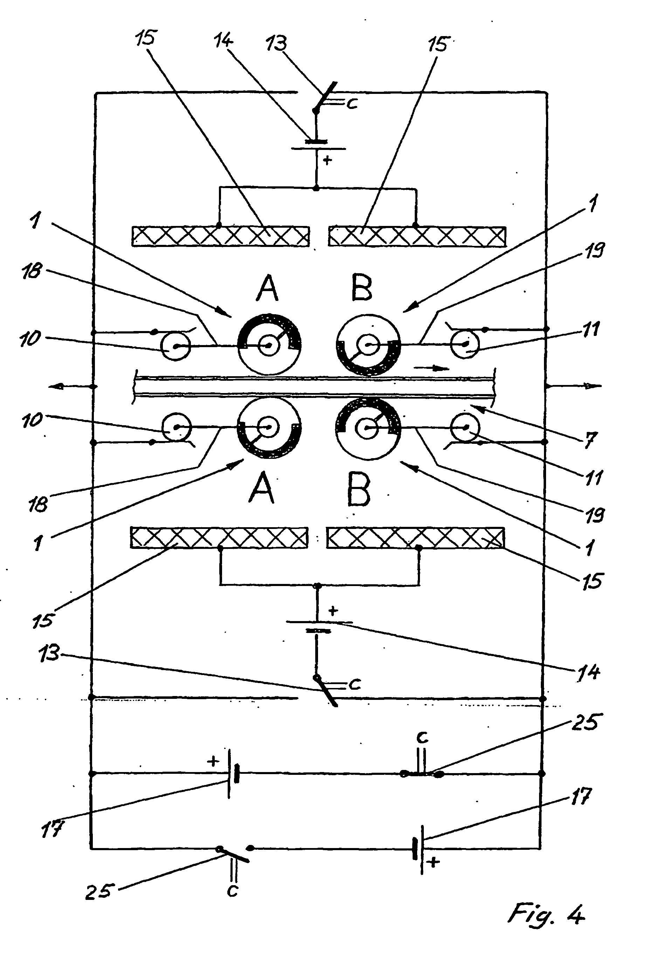

Die **Figur 4** zeigt diese Situation mit den abwechselnd angeordneten Kontakträdern 1. Alle Kontakträder 1 sind so angetrieben, dass sich ihre Phasenlage im Betrieb nicht ändert. Dies kann mittels synchroner elektronischer Antriebe und/oder Zahnrad- bzw. Zahnriemenantriebe erfolgen. Zur Entmetallisierung sind hier zwei Entmetallisierungs-Gleichrichter 17 vorgesehen. Dies verringert den Aufwand an Schaltmitteln im Vergleich zu einer Umpolschaltung und die Kontakträder 1 A und B können mit individuellen Stromdichten entmetallisiert werden. Die Anordnung der Kontakträder 1 kann in Transportrichtung in gleicher Weise fortgesetzt werden.

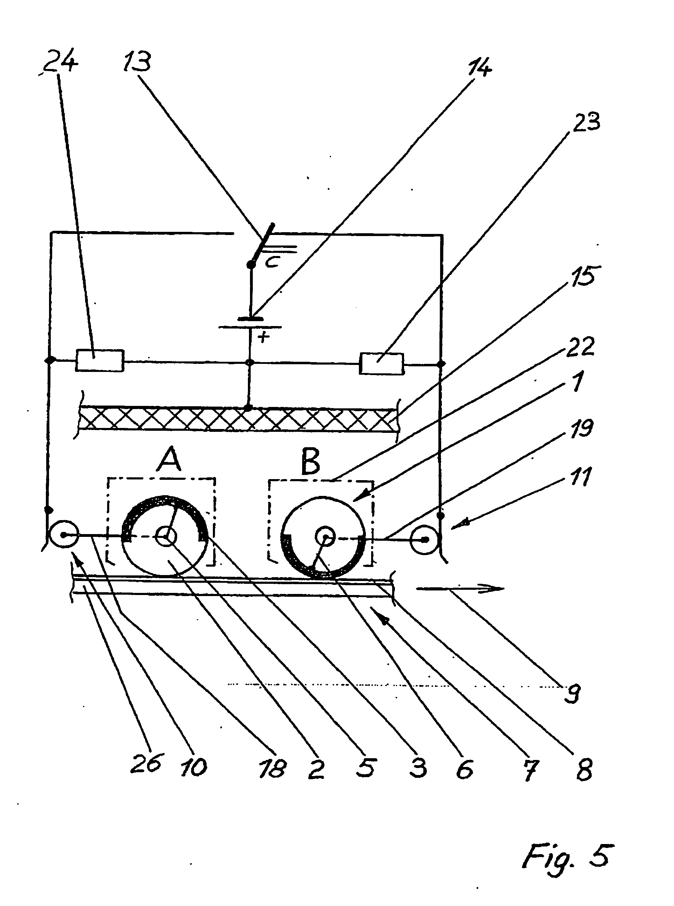

Das Ausführungsbeispiel der **Figur 5** stellt eine sehr wirtschaftliche Lösung für das Metallisieren des Gutes und für das Entmetallisieren der Bogenkontakte 3 dar. Hier werden keine zusätzlichen Entmetallisierungs-Gleichrichter mit den zugehörigen Mitteln zum Schalten, Steuern und Synchronisieren benötigt. Die Entmetallisierung der Bogenkontakte 3 erfolgt über je einen Vorwiderstand 23, 24. Der Bogenkontakt des Kontaktrades 1 B ist wieder über einen Schleifkontakt 11 und den Umschalter 13 mit dem negativen Pol des Gleichrichters 14 elektrisch verbunden. Die Leitschicht 8 auf dem Substrat 26 des Gutes 7 wird vom Bogenkontakt 3 des Kontaktrades 1 B kathodisch gepolt. Der Pluspol des Gleichrichters 14 ist an der Anode 15 angeschlossen. Damit wird die Oberfläche des Gutes 7 elektrolytisch metallisiert. Der Vorwiderstand 23 B ist parallel zum Gleichrichter 14 geschaltet. Er stellt einen zusätzlichen Verbraucher dar. Gleichzeitig wird über den Vorwiderstand 24 A und den zugehörigen Schleifkontakt 10 der Bogenkontakt 3 des Kontaktrades 1 A mit dem Pluspol des Gleichrichters 14 verbunden. Durch diese anodische Polarität des Bogenkontaktes 3 gegen die kathodische Oberfläche des Gutes 7 wird der Bogenkontakt 3 elektrolytisch entmetallisiert. Weil der erforderliche Entmetallisierungsstrom wegen der kleinen Fläche der Bogenkontakte nur 1/10 bis 1/100 des Metallisierungsstromes in der elektrolytischen Zelle beträgt, können die in den elektrischen Leitungen vom Gleichrichter zum jeweiligen Bogenkontakt vorhandenen Vorwiderstände 23, 24 im Widerstandswert so groß dimensioniert werden, dass die Verlustleistung im Vergleich zur Leistung der Galvanisierzelle vernachlässigbar ist. Damit kann eine extrem kostengünstige Durchlauf-Galvanisieranlage realisiert werden.

Bei jeder halben Umdrehung der Kontakträder 1 wechselt auch der Umschalter 13 seine Schaltstellung, so dass sich auch die Polaritäten an den Bogenkontakten von zwei zueinander benachbarten Kontakträdern entsprechend ändern. Bei einem elektronischen Umschalter 13 kann zum Umschalten eine kleine Zeit gewählt werden, z.B. 0,1 ms. Bei einem elektromechanischen Umschalter beträgt diese Zeit z.B. 10 ms. Auch diese längere Zeit, die als Pausenzeit wirkt, ist für den elektrolytischen Prozess problemlos, selbst wenn keine weiteren Kontakträder 1 das Gut momentan kontaktieren. In manchen Fällen ist sogar ein unipolarer Pulsstrom erforderlich, d.h. ein Strom mit Lücken.

Auch ein bipolarer Pulsstrom ist mit dieser wirtschaftlichen elektrischen Schaltung anwendbar. Damit die meist energiereichen Rückwärtsstrompulse nicht zur Metallisierung der Bogenkontakte 3 beitragen können, werden in Serie zu den in den elektrischen Leitungen vom Gleichrichter zum jeweiligen Bogenkontakt vorgesehenen Vorwiderständen 23, 24 Dioden so gepolt eingefügt, dass ihre Anoden zum Pluspol des Gleichrichters weisen. Zur Vermeidung der Verlustleistung könnten an Stelle der Vorwiderstände 23, 24 auch Schalter 25 verwendet werden. Diese werden nur dann von der Steuereinheit C geschlossen, wenn der zugehörige Bogenkontakt 3 entmetallisiert werden soll. In der Figur 5 wäre dies momentan der linke Pfad zum Kontaktrad 1 A. Der Umschalter 13 wird wieder von der zentralen Steuereinheit C gesteuert. Entsprechend der momentanen Phasenlage der Kontakträder 1 wird der Umschalter 13 geschaltet.

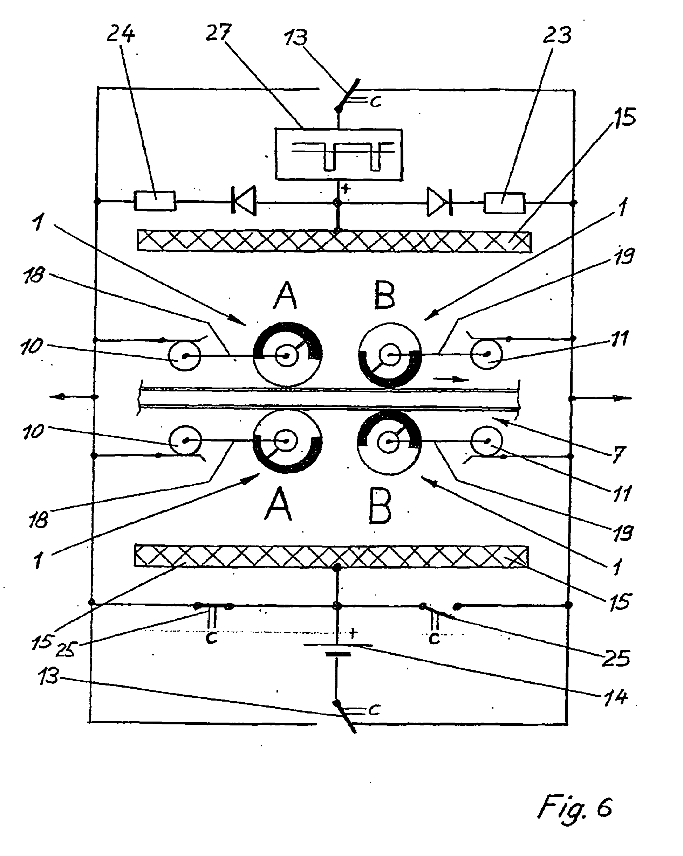

Die **Figur 6** zeigt mögliche Anordnungen der Kontakträder 1 an beiden Seiten des Gutes unter Verwendung der Schaltung gemäß der Figur 5. Die Oberseite zeigt als Beispiel die beschriebene Diodenschaltung für den bipolaren Pulsstrom des Pulsgleichrichters 27. Die Unterseite zeigt als Beispiel Schalter 25 an Stelle der Vorwiderstände zur Vermeidung der Verlustleistung.

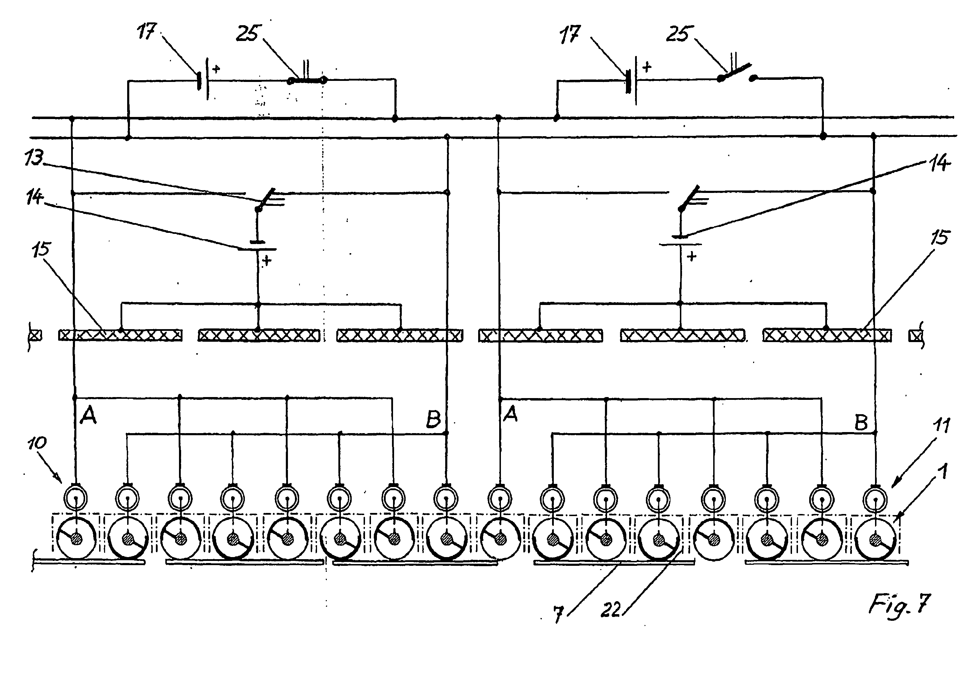

Die **Figur 7** zeigt einen größeren Ausschnitt aus einer Durchlauf-Galvanisieranlage zur einseitigen Metallisierung von Gut 7. Zur Metallisierung dienen die Gleichrichter 14, die als Beispiel mehrere Anoden 15 speisen. Die Entmetallisierung erfolgt mittels zweier Entmetallisierungs-Gleichrichter 17, die von Schaltern 25 zeitlich richtig mit ihren jeweiligen Pluspolen an die Bogenkontakte 3 der Kontakträder 1 der gesamten Anlage oder abschnittsweise an diese geschaltet werden. Die Umschalter 13 und Schalter 25 werden, wie bereits beschrieben, synchron von der Steuereinheit C gesteuert und geschaltet.

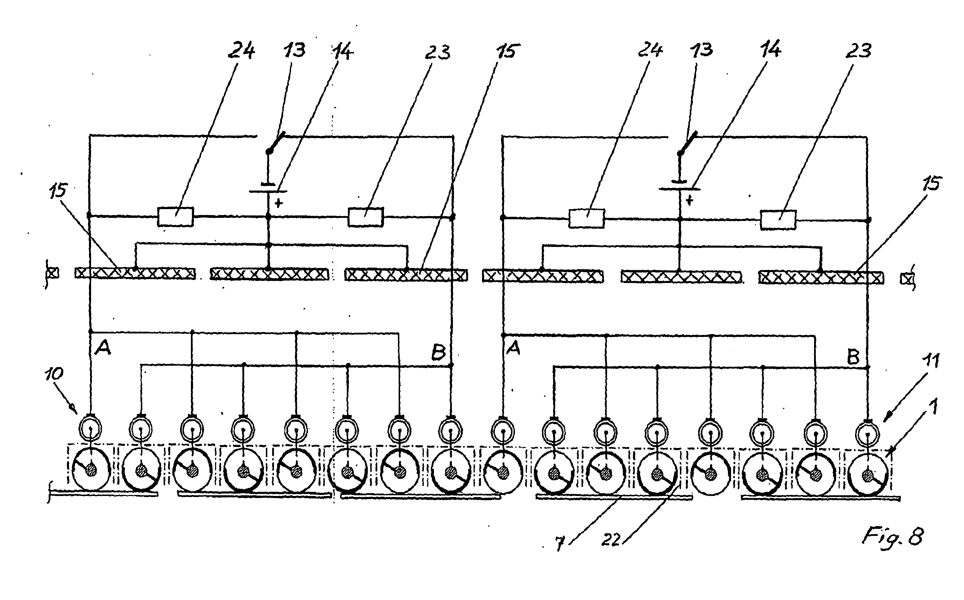

Die **Figur 8** zeigt einen größeren Ausschnitt einer Durchlauf-Galvanisieranlage unter Verwendung der Schaltung gemäß der Figur 5. Auch hier können mehrere Anoden 15 von einem Gleichrichter 14 gespeist werden.

Mit dieser Schaltung erfolgt die Entmetallisierung der Bogenkontakte 3 mit nahezu gleich großer Spannung wie die Metallisierung des Gutes. Hier entfällt jedoch die Möglichkeit der individuellen Einstellung der Ströme zur Metallisierung und zur Entmetallisierung. Weil jedoch wesentlich weniger Metall zu entmetallisieren ist als in der elektrolytischen Zelle zu metallisieren, werden auch mit dieser wirtschaftlichen Schaltung sehr gute Entmetallisierungs-ergebnisse erzielt. Bei dieser elektrischen Schaltung kann eine dargestellte Gruppe zur anderen auch asynchron, d.h. abweichend von 180° Phasenverschiebung, realisiert werden. Die Gruppen sind untereinander unabhängig.

Die erfindungsgemäße Kontaktierung von Gut in elektrolytischen Anlagen eignet sich sowohl zur vollflächigen elektrolytischen Behandlung als auch zur Behandlung von strukturiertem Gut, wie z.B. beim Leiterbildaufbau von Leiterplatten oder von Solarzellen. In allen Fällen sind die Strukturen untereinander elektrisch leitfähig miteinander verbunden und damit zur elektrolytischen Behandlung geeignet. Zur Behandlung rollen die Kontakträder 1 auf vorgesehenen Spuren in Transportrichtung ab und kontaktieren auf diesen das Gut. Bei Leiterplatten verlaufen die Spuren an einem oder an beiden Rändern je Seite. Bei Solarzellen verlaufen die Spuren ebenfalls an den Rändern oder auf breiteren Stromfängern auf der Vorderseite oder auf der elektrisch leitfähigen Rückseite, die mit der Struktur an der Vorderseite in elektrischer Verbindung steht.

Bei entsprechend ausgestalteten Anlagen ist es ferner auch möglich, dass quer zur Transportrichtung der Durchlaufanlage mehrere plattenförmige Teile oder mehrere bandförmige Bänder nebeneinander elektrisch kontaktiert und elektrolytisch behandelt werden.

### Liste der Bezugszeichen und Abkürzungen

- 1: Kontaktrad, Rotationsteil
- 2: Isolierkörper
- 3: Bogenkontakt
- 4: Bogenlänge
- 5: Achse
- 6: elektrischer Leiter
- 7: Gut, Behandlungsgut
- 8: Leitschicht, Startschicht
- 9: Transportrichtung
- 10: Schleifkontakt, Drehkontakt am Rand A
- 11: Schleifkontakt, Drehkontakt am Rand B
- 12: Antrieb, Motor
- 13: Umschalter, Schaltmittel
- 14: Gleichrichter elektronisch, elektromechanisch
- 15: Anode, Elektrode löslich, unlöslich
- 16: Umpolschaltung, Schaltmittel
- 17: Entmetallisierungs-Gleichrichter elektronisch, elektromechanisch
- 18: Achsbereich A
- 19: Achsbereich B
- 20: Kontaktspur
- 21: leitfähige Brücke
- 22: Abschirmhaube
- 23: Vorwiderstand B
- 24: Vorwiderstand A
- 25: Schalter
- 26: Substrat
- 27: Pulsgleichrichter
- C: Steuereinheit, Kontrolleinheit, Control
- α: Zentriwinkel

## Patentansprüche

1. Vorrichtung zur elektrischen Kontaktierung von flachem plattenförmigem oder bandförmigem Gut (7), das auf einer Durchlaufbahn durch eine elektrolytische Durchlaufanlage mittels mindestens eines Rotationsteiles (1) transportierbar ist, wobei das Rotationsteil (1) konfiguriert ist, in einem Elektrolyten auf einer Oberseite und/oder auf einer Unterseite des Gutes elektrisch kontaktierend abzurollen, um ein Kontaktrad (1) zu bilden, **dadurch gekennzeichnet, dass** das Kontaktrad entlang seines Umfanges einen einzigen elektrisch leitfähigen Bogenkontakt (3) aufweist, wobei ein zu dem Kontaktrad in einem vorbestimmten Abstand benachbart angeordnetes zusätzliches Kontaktrad einen einzigen zusätzlichen elektrisch leitfähigen Bogenkontakt aufweist, und die Bogenkontakte beider Kontakträder in einem Winkel zueinander versetzt angeordnet sind, wobei der Bogenkontakt des jeweiligen Kontaktrades während einer vollständigen Umdrehung des jeweiligen Kontaktrades zunächst kathodisch und anschließend anodisch oder zunächst anodisch und dann kathodisch jeweils gegen die Oberfläche des Gutes mittels elektrischer Schaltmittel (13, 16, 25) in Kombination mit Schleif- und/oder Drehkontakten (10, 11) schaltbar ist.

2. Vorrichtung nach Anspruch 1, **gekennzeichnet durch** mindestens ein Kontaktpaar, welches zwei in dem vorbestimmten Abstand benachbart angeordnete Kontakträder (1) aufweist, wobei diese auf einer Achse (5) platziert sind.

3. Vorrichtung nach Anspruch 1, **gekennzeichnet durch** mindestens ein Kontaktpaar, welches zwei in dem vorbestimmten Abstand benachbart angeordnete Kontakträder aufweist, wobei diese auf unterschiedlichen Achsen (5) platziert sind.

4. Vorrichtung nach Anspruch 1, **gekennzeichnet durch** mindestens ein Kontaktpaar, das zwei Kontakträder (1) aufweist, wobei die Kontakträder (1) entweder auf zwei Achsen (5) an der Oberseite des Gutes angeordnet sind, oder ein Kontaktrad auf einer ersten Achse an der Oberseite des Gutes und ein anderes Kontaktrad auf einer zweiten Achse an der Unterseite des Gutes angeordnet sind.

5. Vorrichtung nach einem der Ansprüche 1 bis 4, **dadurch gekennzeichnet, dass** der Bogenkontakt einen Zentriwinkel (α) im Bereich von 45° bis 315°, bevorzugt 185° bis 200°, aufweist.

6. Vorrichtung nach einem der Ansprüche 1 bis 5, **dadurch gekennzeichnet, dass** die Bogenkontakte beider Kontakträder in einem Winkel von 180° zueinander versetzt angeordnet sind.

7. Vorrichtung nach einem der Ansprüche 1 bis 6, **gekennzeichnet durch** einen oder mehrere Gleichrichter (14, 17), der oder die über Schaltmittel (16, 25) und Schleifkontakte oder Drehkontakte (10, 11) mit den Bogenkontakten (3) der Kontakträder (1) elektrisch verbindbar ist oder sind.

8. Vorrichtung nach einem der Ansprüche 1 bis 7, **gekennzeichnet durch** eine Steuereinheit (C) zur Synchronisation, Steuerung und/oder Regelung der Stromquellen, der Schaltvorgänge der Schaltmittel (13, 16) und des Antriebes (12) der Rotationsteile sowie der Gleichrichter (14, 17).

9. Vorrichtung nach einem der Ansprüche 1 bis 8, **gekennzeichnet durch** mindestens einen Drehkontakt oder Schleifkontakt (10, 11) in einem Bereich eines Achsendes oder in Bereichen beider Achsenden (18, 19) eines Rotationsteiles.

10. Verfahren zur elektrischen Kontaktierung von flachem plattenförmigem oder bandförmigem Gut (7), das auf einer Durchlaufbahn durch eine elektrolytische Durchlaufanlage mittels mindestens eines Rotationsteiles (1) transportiert wird, wobei das Rotationsteil in einem Elektrolyten auf einer Oberseite und/oder auf einer Unterseite des Gutes elektrisch kontaktierend abrollt, um ein Kontaktrad (1) zu bilden, **dadurch gekennzeichnet, dass** ein entlang des Umfanges des Kontaktrades angeordneter Bogenkontakt (3), welcher der einzige elektrisch leitfähige Bogenkontakt des Kontaktrades ist, während einer vollständigen Umdrehung des Kontaktrades zunächst kathodisch und anschließend anodisch oder zunächst anodisch und dann kathodisch jeweils gegen die Oberfläche des Gutes mittels elektrischer Schaltmittel (13, 16, 25) in Kombination mit Schleif- und/oder Drehkontakten (10, 11) geschaltet wird, wobei ein zu dem Kontaktrad in einem vorbestimmten Abstand benachbart angeordnetes zusätzliches Kontaktrad einen einzigen zusätzlichen elektrisch leitfähigen Bogenkontakt aufweist, und die Bogenkontakte beider Kontakträder in einem Winkel zueinander versetzt angeordnet sind.

11. Verfahren nach Anspruch 10, **dadurch gekennzeichnet, dass** die Umschaltung der Polaritäten an den Bogenkontakten von zwei zueinander benachbarten Kontakträdern nach einer halben Umdrehung jedes Kontaktrades erfolgt.

12. Verfahren nach Anspruch 10 oder 11, **dadurch gekennzeichnet, dass** durch mindestens einen Gleichrichter (14) die elektrolytische Behandlung des Gutes und durch mindestens einen Entmetallisierungs-Gleichrichter (17) die Entmetallisierung der Bogenkontakte erfolgt.

13. Verfahren nach einem der Ansprüche 10 bis 12, **dadurch gekennzeichnet, dass** eine Steuereinheit (C) die Schaltvorgänge der Schaltmittel (13, 16) und die Antriebe (12) der Rotationsmittel sowie die Gleichrichter (14, 17) synchronisiert, steuert und/oder regelt.

14. Verfahren nach Anspruch 12 oder 13, **dadurch gekennzeichnet, dass** mittels des Gleichrichters (14) zur elektrolytischen Behandlung des Gutes in der elektrolytischen Zelle während dieser Behandlung der momentan nicht mit dem Gut in Kontakt befindliche Bogenkontakt des Kontaktrades eines Kontaktpaares elektrolytisch entmetallisiert wird.

15. Verfahren nach einem der Ansprüche 12 bis 14, **dadurch gekennzeichnet, dass** Gleichrichter (14, 17) über Schaltmittel (16, 25) und Schleifkontakte oder Drehkontakte (10, 11) mit den Bogenkontakten (3) der Kontakträder (1) elektrisch verbunden werden.

## Claims

1. Apparatus for the electrical contacting of flat plate-like or band-like good (7) which is transportable on a continuous track through an electrolytic in-line plant by means of at least one rotation part (1), wherein the rotation part (1) is configured to roll off in an electrically contacting manner on an upper and/or lower side of the good in an electrolyte in order to form a contact wheel (1), **characterized in that** the contact wheel has along its circumference one single electrically conductive arc contact (3), wherein an additional contact wheel which is adjacently arranged to the contact wheel in a pre-determined distance has one single additional electrically conductive arc contact, and the arc contacts of both contact wheels are arranged offset at an angle to each other, wherein the arc contact of the respective contact wheel is switchable during a complete rotation of the respective contact wheel at first cathodic and subsequently anodic, or at first anodic and then cathodic against the surface of the good by means of electric switching means (13, 16, 25) in combination with sliding and/or rotation contacts (10, 11).

2. Apparatus according to claim 1, **characterized by** at least one contact pair having two contact wheels which are adjacently arranged in the pre-determined distance, wherein these are arranged on one axle (5).

3. Apparatus according to claim 1, **characterized by** at least one contact pair having two contact wheels (1) which are adjacently arranged in the pre-determined distance, wherein the same are arranged on different axles (5).

4. Apparatus according to claim 1, **characterized by** at least one contact pair having two contact wheels (1), wherein the contact wheels (1) are either arranged on two axles (5) at the upper side of the good, or one contact wheel is arranged on a first axle at the upper side of the good, and another contact wheel is arranged on a second axle at the lower side of the good.

5. Apparatus according to any of claims 1 to 4, **characterized in that** the arc contact has a center angle (α) in the range of 45° to 315°, preferably of 185° to 200°.

6. Apparatus according to any of claims 1 to 5, **characterized in that** the arc contacts of both contact wheels are arranged offset at an angle of 180° to each other.

7. Apparatus according to any of claims 1 to 6, **characterized by** one or several rectifiers (14, 17) which is or are electrically connectable with the arc contacts (3) of the contact wheels (1) via switching means (16, 25) and sliding contacts or rotation contacts (10, 11).

8. Apparatus according to any of claims 1 to 7, **characterized by** a control unit (C) for synchronization, control and/or regulation of the power sources, the switching actions of the switching means (13, 16), and the drive (12) of the rotation parts, as well as the rectifiers (14, 17).

9. Apparatus according to any of claims 1 to 8, **characterized by** at least one rotation contact or sliding contact (10, 11) in a region of an axle end or in the regions of both axle ends (18, 19) of a rotation part.

10. Method for the electrical contacting of flat plate-like or band-like good (7) which is transported on a continuous track through an electrolytic in-line plant by means of at least one rotation part (1), wherein the rotation part rolls off in an electrically contacting manner on an upper and/or lower side of the good in an electrolyte in order to form a contact wheel (1), **characterized in that** an are contact (3) which is arranged along the circumference of the contact wheel and which is the only electrically conductive arc contact of the contact wheel, switches during a complete rotation of the contact wheel at first cathodic and subsequently anodic, or at first anodic and then cathodic against the surface of the good by means of electric switching means (13, 16, 25) in combination with sliding and/or rotation contacts (10, 11), wherein an additional contact wheel which is adjacently arranged to the contact wheel in a pre-determined distance has one single additional electrically conductive arc contact, and the are contacts of both contact wheels are arranged offset at an angle to each other.

11. Method according to claim 10, **characterized in that** the switching of the polarities at the are contacts of two adjacently arranged contact wheels takes place after half a rotation of each contact wheel.

12. Method according to claim 10 or 11, **characterized in that** the electrolytic treatment of the good takes place by means of at least one rectifier (14), and that the demetallization of the arc contacts takes place by means of at least one demetallization rectifier (17).

13. Method according to any of claims 10 to 12, **characterized in that** a control unit (C) synchronizes, controls and/or regulates the switching actions of the switching means (13, 16), and the drives (12) of the rotation means, as well as the rectifiers (14, 17),

14. Method according to claim 12 or 13, **characterized in that**, during the electrolytic treatment of the good in the electrolytic cell, that arc contact of the contact wheel of a contact pair which is currently not in contact with the good is electrolytically demetallized by means of the rectifier (14).

15. Method according to any of claims 12 to 14, **characterized in that** rectifiers (14, 17) are electrically connected with the arc contacts (3) of the contact wheels (1) via switching means (16, 25) and sliding contacts or rotation contacts (10, 11).

## Revendications

1. Appareil pour le contact électrique de bien plat en forme de plaque ou de bande (7) qui est transportable sur une piste passante à travers une ligne d'électrolyse au moyen d'au moins un élément rotatif (1), dans lequel l'élément rotatif (1) est configuré pour former une roue de contact (1) qui fait rouler par contact électrique dans un électrolyte sur une face supérieure et/ou sur une face inférieure du bien, **caractérisé en ce que** la roue de contact comprend au long de sa circonférence un arc de contact (3) unique conducteur électrique, dans lequel une roue de contact supplémentaire, localisée au voisinage de la roue de contact à une distance prédéfinie, possède un arc de contact unique conducteur électrique supplémentaire, et les arcs de contact des deux roues de contact sont décalés l'un par rapport à l'autre selon un angle, dans lequel l'arc de contact de chaque roue de contact est commutable pendant un tour complet de la roue de contact correspondante d'abord en cathode puis en anode, ou d'abord en anode puis en cathode contre la surface du bien par l'intermédiaire de commutateurs électriques (13, 16, 25) en combinaison avec des contacts glissants et/ou rotatifs (10, 11).

2. Appareil selon la revendication 1, **caractérisé par** au moins une paire de contact comprenant deux roues de contact (1) localisées l'une à coté de l'autre à la distance prédéfinie, lesquelles étant placées sur un axe (5).

3. Appareil selon la revendication 1, **caractérisé par** au moins une paire de contact comprenant deux roues de contact (1) localisées l'une à coté de l'autre à la distance prédéfinie, lesquelles étant placées sur des axes différents (5).

4. Appareil selon la revendication 1, **caractérisé par** au moins une paire de contact comprenant deux roues de contact (1), dans lequel les roues de contact (1) sont soit localisées sur deux axes (5) sur la face supérieure du bien, ou bien une roue de contact est localisée sur un premier axe sur la face supérieure du bien et une autre roue de contact est localisée sur un second axe sur la face inférieure du bien.

5. Appareil selon une des revendications 1 à 4, **caractérisé en ce que** l'arc de contact a un angle d'ouverture (α) compris entre 45° et 315°, préférentiellement de 185° à 200°.

6. Appareil selon une des revendications 1 à 5, **caractérisé en ce que** les arcs de contact des deux roues de contact sont ordonnés selon un angle de 180° l'un par rapport à l'autre.

7. Appareil selon une des revendications 1 à 6, **caractérisé par** un ou plusieurs redresseurs (14, 17) qui peut ou peuvent être relié(s) électriquement avec les arcs de contact (3) des roues de contact (1) par l'intermédiaire de commutateurs (16, 25) et des contacts glissants ou rotatifs (10, 11).

8. Appareil selon une des revendications 1 à 7, **caractérisé par** une unité de commande (C) pour la synchronisation, le contrôle et/ou la régulation des sources de courant, des actions de commutation des commutateurs électriques (13, 16), et du propulseur (12) des éléments rotatifs, ainsi que des redresseurs (14, 17).

9. Appareil selon une des revendications 1 à 8, **caractérisé par** au moins un contact rotatif ou un contact glissant (10, 11) dans la partie terminale d'un axe ou dans les parties terminales des deux axes (18, 19) de l'élément rotatif.

10. Méthode pour le contact électrique de bien plat en forme de plaque ou de bande (7) qui est transporté sur une piste passante à travers une ligne d'électrolyse au moyen d'au moins un élément rotatif (1), dans lequel l'élément rotatif fait rouler par contact électrique dans un électrolyte sur une face supérieure et/ou sur la face inférieur du bien pour former une roue de contact (1), **caractérisée en ce que** un arc de contact (3) qui est localisé le long de la circonférence de la roue de contact, lequel est l'unique arc de contact conducteur électrique de la roue de contact, commute pendant un tour complet de la roue de contact d'abord en cathode puis en anode, ou d'abord en anode puis en cathode contre la surface du bien par l'intermédiaire de commutateurs électriques (13, 16, 25) en combinaison avec des contacts glissants et/ou rotatifs (10, 11), dans laquelle une roue de contact supplémentaire localisée au voisinage de la roue de contact à une distance prédéfinie possède un arc de contact unique conducteur électrique supplémentaire, et les arcs de contact des deux roues de contact sont décalés l'un par rapport à l'autre selon un angle.

11. Méthode selon la revendication 10, **caractérisée en ce que** la commutation des polarités des arcs de contact de deux roues de contact voisines se produit après une demi-rotation de chaque roue de contact.

12. Méthode selon une des revendications 10 ou 11, **caractérisée en ce que** le traitement électrolytique du bien se produit par au moins un redresseur (14), et que la démétallisation des arcs de contact se produit par au moins un redresseur pour la démétallisation (17).

13. Méthode selon une des revendications 10 à 12, **caractérisée en ce qu'**une unité de commande (C) synchronise, contrôle et/ou régule les actions de commutation des commutateurs (13, 16), et les propulseurs (12) des éléments rotatifs, ainsi que les redresseurs (14, 17).

14. Méthode selon la revendication 12 ou la revendication 13, **caractérisée en ce que** par l'intermédiaire du redresseur (14) pour le traitement électrolytique du bien dans la cellule d'électrolyse, l'arc de contact de la roue de contact d'une paire de contact qui momentanément pendant ce traitement ne se trouve pas en contact avec le bien est démétallisé par électrolyse.

15. Méthode selon une des revendications 12 à 14, **caractérisée en ce que** les redresseurs (14, 17) sont reliés électriquement par des commutateurs (16, 25) et des contacts glissants ou rotatifs (10, 11) avec les arcs de contact (3) des roues de contact (1).
